# EUROPEAN PATENT SPECIFICATION

(11) **EP 3 874 110 B1**
(45) Date of publication and mention of the grant of the patent: **10.05.2023**
(21) Application number: 19801631.3
(22) Date of filing: 28.10.2019
(51) Int. Cl.: E06B 3/663, H01L 31/048

(54) **INSULATING GLAZING WITH LUMINESCENT SOLAR CONCENTRATOR FOR PRODUCTION OF ELECTRICAL ENERGY**
ISOLIERGLASSCHEIBE MIT LEUCHTENDEM SOLARKONZENTRATOR ZUR ERZEUGUNG ELEKTRISCHER ENERGIE
VITRAGE ISOLANT AVEC CONCENTRATEUR SOLAIRE LUMINESCENT POUR LA PRODUCTION D'ÉNERGIE ÉLECTRIQUE

(30) Priority: 30.10.2018 IT 201800009908
(43) Date of publication of application: 08.09.2021
(73) Proprietor: Università degli Studi di Milano - Bicocca, 20126 Milano (IT); Glass To Power S.p.A., 38068 Rovereto (TN) (IT)
(72) Inventor: MEINARDI, Francesco, 23900 Lecco (IT); BROVELLI, Sergio, 20162 Milano (IT); BRUNI, Francesco, 20063 Cernusco sul Naviglio (MI) (IT); GANDINI, Marina, 20159 Milano (IT)
(74) Representative: Ripamonti, Enrico
(86) International application number: PCT/IB2019/059229
(87) International publication number: WO 2020/089772

(56) References cited:
- EP-A1- 0 199 233
- WO-A1-2015/152011
- WO-A1-2018/132491
- BE-A5- 1 000 298
- GB-A- 2 531 757
- US-A1- 2014 130 864

## Description

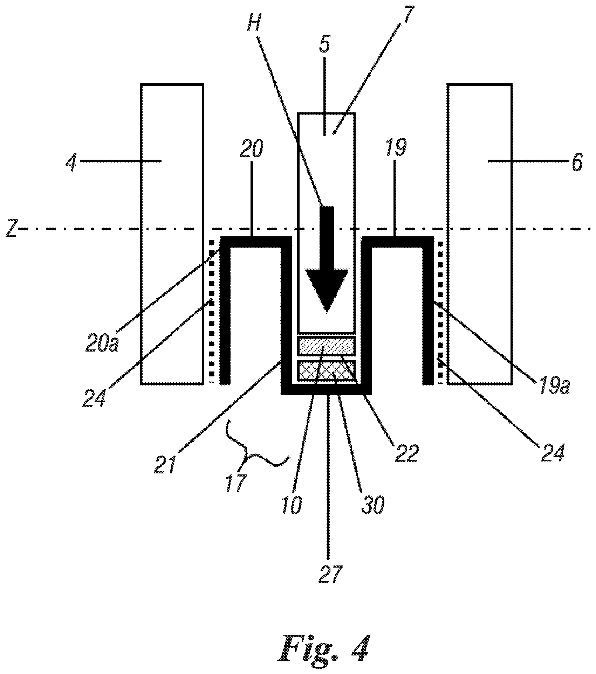

The subject of the present invention is an insulating glazing according to the preamble of the main claim which can be read in figure 4 of BE1000298A5.

As is known, multi-glass insulating glazing is constituted by at least two vitreous or plastics panels which are transparent or semi-transparent, and are separated from one another by sealed spacers. Between the panels there is thus present a chamber usually filled with gas which has low thermal conductivity (for example argon, krypton), making it possible to improve the thermal insulation of the insulating glazing.

In this conventional architecture, the insulating glazing is used to constitute continuous glass walls in buildings with a continuous facade, and to close openings of windows, French windows or the like (and in this case they are provided with a frame). However, the known insulating glazing does not make it possible to produce energy from the solar radiation which strikes its panels.

Luminescent solar concentrators are also known which are particularly suitable for transforming the solar radiation supplied to them into electrical energy.

As is known, luminescent solar concentrators (or LSCs) comprise a glass or plastics waveguide which defines the body of the concentrator, which body is coated or doped with highly emissive elements or components commonly known as fluorophores. The direct and/or diffused sunlight is absorbed by these fluorophores, and is re-emitted with a greater wavelength. The luminescence thus generated is propagated by means of total internal reflection to the edges of the waveguide, and is converted into electrical energy by photovoltaic cells which are coupled to the perimeter of the body of the concentrator.

By selecting appropriately the concentration of fluorophores in the waveguide and their optical properties, it is possible to produce coloured or colourless devices with the required level of transparency and an arbitrary form, which devices can easily be integrated architecturally as photovoltaic insulating glazing for example.

US2014/130864 describes a transparent solar concentrator used in a window of the type with two panels, each of which can comprise a solar concentrator.

WO2015/152011 describes a multi-layer panel comprising two glass panels between which there is placed a flat element made of resin. Spacers are placed between the panels and the element made of resin, whereas the element made of resin is inserted, at a perimeter portion thereof, within a groove in a metal frame disposed between said spacers. Sealing elements are placed between the glass panels and the metal frame within a hollow space which is present between the panels and the element made of resin.

In the groove in the metal frame there is placed a pad material which can receive the adjacent edge of the element made of resin; this pad material need also not be placed on both the sides of the frame, or it can be disposed partially within the groove.

The use of the flat element made of resin is necessary since it can improve the resistance to breakage of the multi-layer panel.

WO2018/132491 describes a window which can generate electricity, and comprises a first and a second flat element made of glass, and a device which can generate electricity if it is struck by sunlight, such as a photovoltaic device, provided on an inner surface of one of these flat elements.

The objective of the present invention is to provide insulating glazing, which as well as the advantages of thermal insulation, also has the possibility of transforming the solar radiation to which it is subjected into electrical energy.

Another objective is to provide insulating glazing wherein the solar cells which are coupled to the perimeter of the body of the solar concentrator constitute an electrical circuit which can generate a uniform quantity of electrical energy along the edges of the concentrator, independently of the fact that some sections of these edges, close to the corners, are reached by less radiation of light.

Another objective is to provide insulating glazing of the aforementioned type which has a long-lasting seal, i.e. photovoltaic insulating glazing wherein the gas with low thermal conductivity contained therein is not subject to leakages over a period of time. Another objective is to provide insulating glazing wherein the electrical energy generated can be transferred in a simple manner to batteries or to an electrical mains supply of the environment in which the insulating glazing is used.

A further objective is to provide insulating glazing which can be used as a source of supply of power to electrical and/or electronic devices which are used within an environment in which the insulating glazing is present, such as anti-theft devices, a Wi-Fi repeater, lighting elements or the like.

These objectives and others which will become apparent to persons skilled in the art are achieved by insulating glazing according to the main claim.

For better understanding of the present invention, purely by way of non-limiting indication, the following drawings are appended, in which:
figure 1 shows an exploded view in perspective, with some parts omitted for the sake of greater clarity, of insulating glazing according to the invention;
figure 2 shows an enlarged partial view in perspective of a lower portion of the insulating glazing in figure 1, with some parts omitted for the sake of greater clarity;
figure 3 shows a lateral view of what is shown in figure 2;
figure 4 shows a lateral view of what is shown in figure 3, but with a dimensional variation of a component of the insulating glazing in figure 1;
figure 5 shows a view in perspective of a component of the insulating glazing in figure 1 according an embodiment of the insulating glazing which is not part of the invention;
figure 6 shows a view in perspective of a variant of the component in figure 5 according to the invention;
figure 7 shows a view similar to that in figure 2, but of a variant of the invention which does not fall within the scope of the present invention;
figure 8 shows a schematic lateral view of the variant in figure 7;
figure 9 shows a view similar to that in figure 8, but with a dimensional variation of a component of the insulating glazing in figure 7;
figure 10A shows a generic profile of emission of photons by the solar concentrator (continuous line P) and the histogram relating to the current produced by solar cells with a constant dimension coupled to the edge of the concentrator. In this configuration, the maximum current which can be obtained (broken line L) is limited by the current generated by the cells at the ends of the concentrator;
figure 10B shows schematically a lateral view of the solar concentrator with solar cells with identical dimensions;
figure 11A shows the same profile of emission of photons by the solar concentrator (continuous line P) in figure 10 and the histogram relating to the current produced by solar cells with a variable dimension coupled to the edge of the concentrator itself, shown in figure 11B. In this configuration, the maximum current which can be obtained (broken line L) is independent from the emission profile along the edges; and
figure 12 shows schematically insulating glazing used in a self-powered "smart window".

With reference to the aforementioned figures, insulating glazing is indicated as 1, and encloses a central portion defined by at least two panels; in the figures, by way of example, the insulating glazing comprises three panels: a first, outer panel 4, an intermediate panel 5, and an inner panel 6, where outer and inner refer to the environment in a single aperture or wall of which the insulating glazing is placed.

The outer panel 4 and the inner panel 6 are made of glass or of plastics material, whereas the intermediate panel 5 is a luminescent solar concentrator (LSC), of a type which in itself is known.

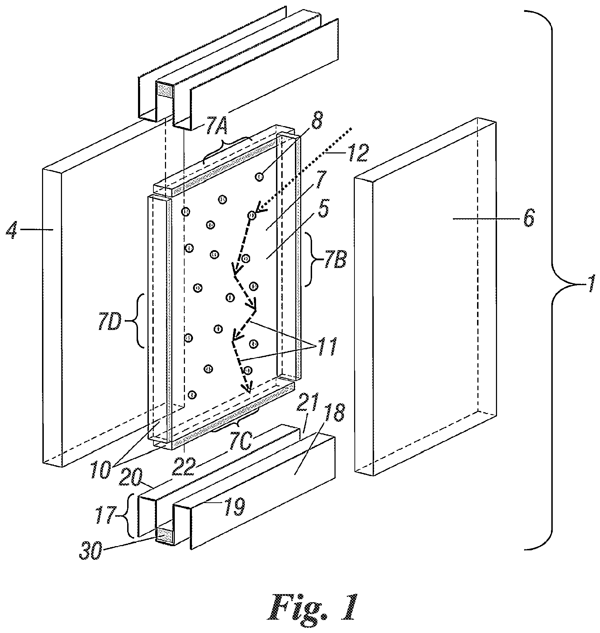

This concentrator or LSC 5 can be either in the form of a solid plate (such as the one in the figures), or a film disposed on a transparent support, for example a plastics material. As is known, the luminescent solar concentrator or LSC 5 also comprises a main body 7 made of glass or plastics material in which there are present emissive substances (which by way of example are shown in figure 1 as elements 8 which can clearly be identified within the body 7).

At edges 7A, 7B, 7C, 7D of the body 7 there are present known photovoltaic cells 10 which can collect the light radiation (indicated as 11 in figure 1) emitted by the emissive substances 8 which are present in the LSC, after the absorption by the substances of incident light radiation (indicated as 12 in figure 1) on the insulating glazing 1. These photovoltaic cells 10 are coupled optically in a known manner on the body 7 of the LSC 5.

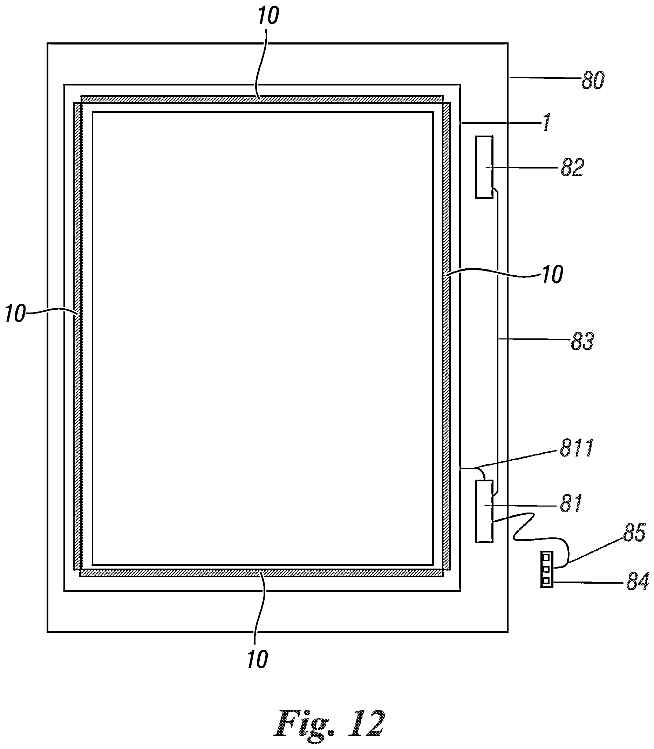

By this means, use of the insulating glazing 1 as described above at a window, a French window (and in this case it is provided with a perimeter counter-frame 80, as shown in figure 12) or in order to define (together with other insulating glazing 1) the wall of an environment, makes it possible to obtain electrical energy from the light radiation which strikes the insulating glazing. However, the known plastics materials which constitute the luminescent solar concentrator 5, or, in any case, the set of materials present in the solar concentrator (produced either in the form of a solid plate or a film on a transparent support) have a coefficient of thermal expansion different from that of the glass of the panels 4 and 6. If this problem were not solved, using conventional architectures for standard insulating glazing, the insulating glazing would soon be damaged as a result of mechanical tensions associated with expansion and/or contraction of the structure.

This problem is solved by the use of spacer units (or simply "spacers") 17 placed at the panels 4-6, which spacers can accept the expansion of the panels themselves, keeping unaltered the seal of the chamber which is present between the panels (and which chamber contains the gas with low thermal conductivity).

In addition, each spacer 17 has a receptacle to accommodate the electrical and photovoltaic components which are present on the perimeter of the luminescent solar concentrator, and permits the electrical contact between the components and the circuit for extraction of the electrical energy.

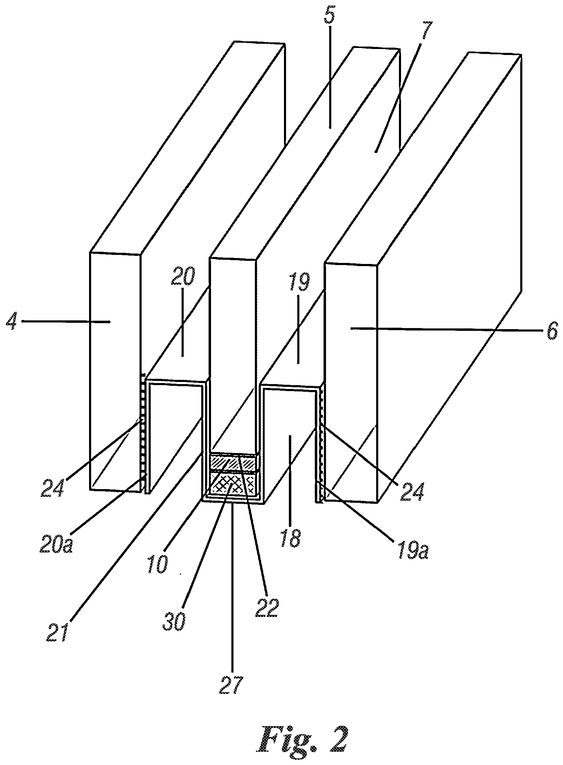

With reference in particular to figures 1-6, each spacer 17 comprises a preformed body 18 with two portions 19 and 20 (formed substantially in the shape of an overturned "U"), which portions are placed at a short distance from one another and delimit a channel 21. A corresponding end 22 of the LSC 5 can be introduced into the channel. On the other hand the portions 19 and 20 have end walls 19A and 20A on the exterior of the spacer which are rendered integral with the panels 4 and 6 thanks to conventional adhesives and seals 24 (for example which are silicone-based).

The channel 21 accommodates the LSC composed of its body 7 and of the photovoltaic cells 10 which are coupled thereto. However, the luminescent solar concentrator or LSC 5 is not integral with the preformed spacer 17, since it is not connected by means of adhesives or adhesive layers to the body 18 of this spacer. The LSC is therefore free to slide in the channel, towards a wall 27 which at the bottom (with reference to the figures) delimits the channel 21 (and connects the portions 19 and 20). This provides the spacer 17 with the possibility of tolerating any expansions or contractions of the luminescent solar concentrator 5.

The spacer 17 can also permit the insertion into the channel 21 of a compensator element 30 which can compensate for the thermal expansion and/or contraction of the LSC 5, in a direction orthogonal to an axis which is perpendicular to the aforementioned wall 27. By way of non-limiting example, this element can be made of a plastic or rubbery material or a foam.

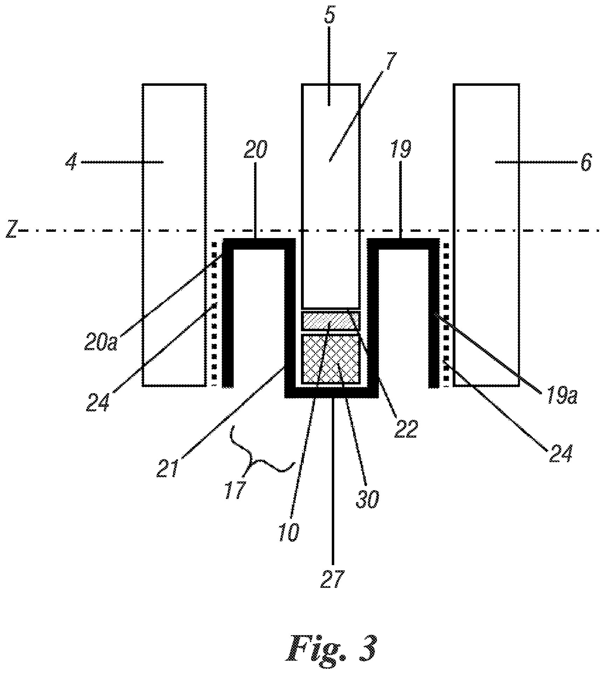

Figure 4 represents schematically the operating principle of the above-described spacer 17 in the case in which the luminescent solar concentrator expands after a variation of temperature; this expansion (indicated by the arrow H) takes place perpendicularly to an axis Z which is orthogonal to the faces with the larger area of the concentrator 5 (i.e. to the wall 27 of the spacer 17). What takes place after this expansion is also shown by a comparison of figures 3 and 4: in the case when the temperature increases, the spacer can accommodate the thermal expansion of the LSC 5, thanks to the compression of the compensator element 30. Consequently, damage and mechanical tensions in the structure of the insulating glazing, which could damage the insulating glazing irreparably (in particular on the frame thereof), are avoided.

Any expansions of the LSC in other directions, such as that of the axis Z, are received within the channel 21, which advantageously has dimensions such as to receive said insulating glazing with play.

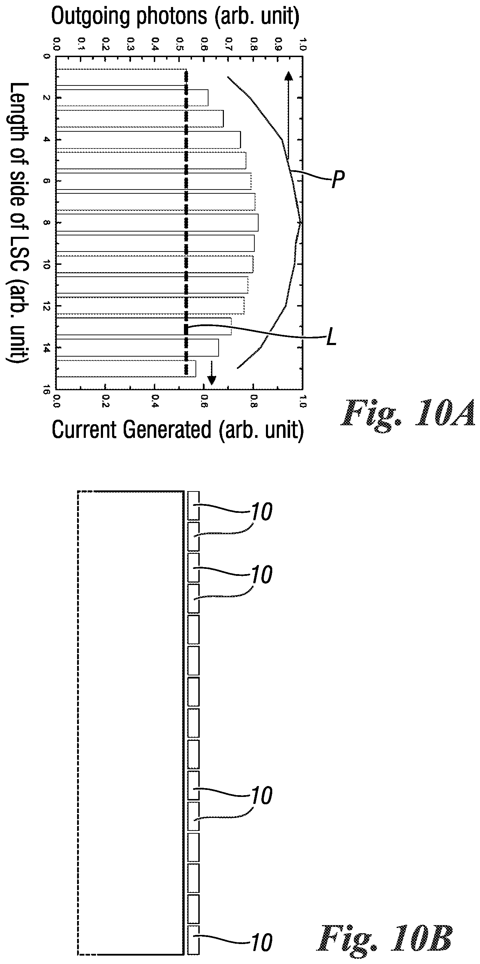

With a rigid spacer 17 as shown in the figures, which rigid spacer has the channel 21 to contain both the luminescent solar concentrator 5 and the compensator element 30, it is necessary to implement solutions in order to permit the electrical coupling between the photovoltaic cells 10 of the solar concentrator 5 and an electrical circuit (not shown) on the exterior of the insulating glazing, which electrical circuit is for example associated with a counter-frame 80 as shown in figure 10.

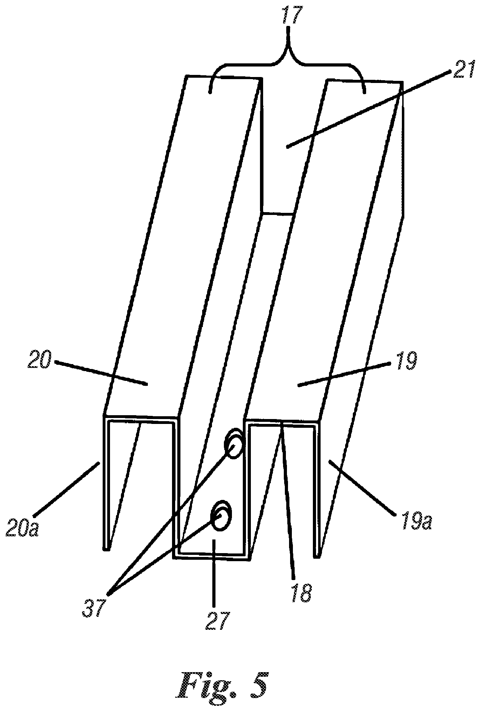

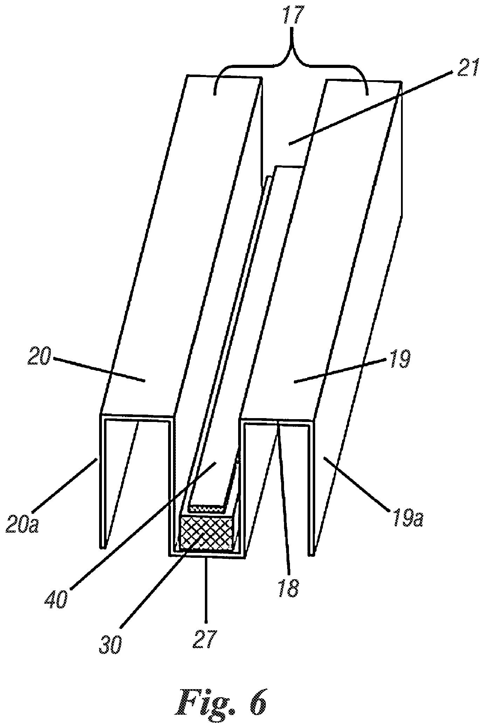

Figures 5 and 6 show two possible solutions to this requirement: according to the configuration in figure 5, which is not part of the invention, through-holes 37 are provided within the wall 27 of the body 18 of the spacer 17, in order to permit the passage of electrical wires or cables (not shown) connected directly to the photovoltaic cells 10 placed at the end 22 of the LSC 5.

Alternatively, according to the invention and to the configuration in figure 6, the spacer 17 has metal contacts 40 disposed between the compensator element and the photovoltaic cells 10 of the LSC 5 (which metal contacts have sliding connectors, not shown). These contacts 40 are thus connected to similar cables or conductors which reach the exterior of the insulating glazing.

In both the solutions, the electrical connection is guaranteed between the solar cells and an external electrical circuit (which in itself is known, and is not shown), which circuit is associated with the fixed structure (for example the counter-frame 80) which surrounds the frame of the insulating glazing (fixed structure shown in figure 12, which will be described hereinafter).

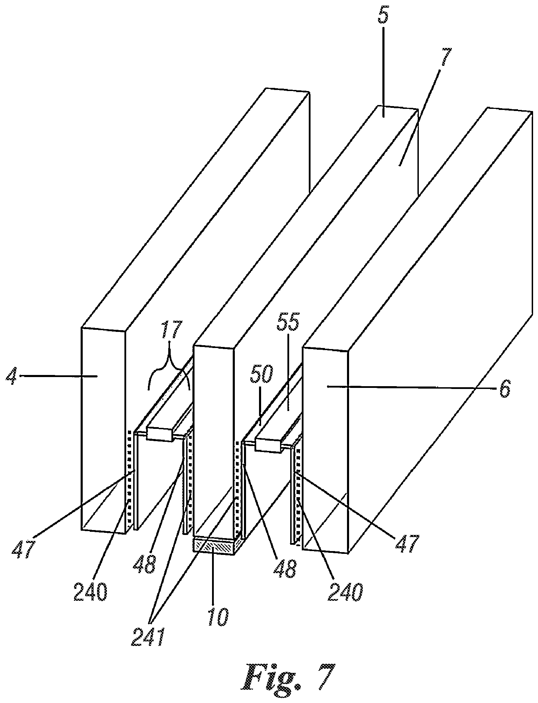

In the variant in figures 7-9 (which is not within the scope of the present invention but where elements corresponding to those already described in relation to figures 1-6 are indicated with the same numerical references), the use of partially flexible spacers 17 is shown, which spacers are disposed between each panel 4 and 6, and the LSC 5. Each spacer comprises a form substantially in the shape of an overturned "U", with parallel arms 47 and 48 which are rigid, and are glued by means of adhesive layers or adhesive 240 and 241 respectively on the outer and inner panels 4 and 6 of the insulating glazing (the sides 47) and the body 7 of the luminescent solar concentrator 5 (the sides 48) .

In the case in question, the spacers 17 are not completely rigid as in the case previously described and shown in figures 1-6, but have a flexible portion 50 which connects the arms 47 and 48. This portion 50 of each spacer 17 allows the spacer to accommodate the thermal expansions or contractions of the luminescent solar concentrator 5 relative to the other panels 4 and 6 made of a different material, without the insulating glazing 1 undergoing damage caused by mechanical stress.

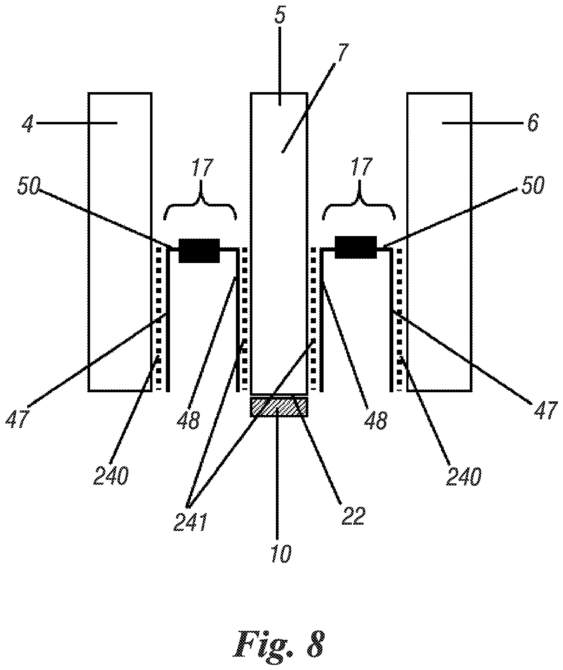

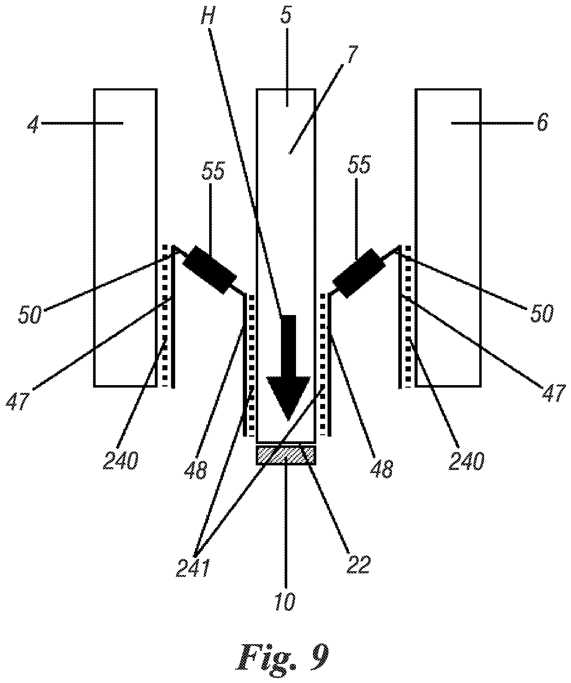

The comparison of figures 8 and 9 shows the deformation of each spacer 17, when the LSC 5 is deformed (arrow H) when it is subjected to thermal variation. It will be appreciated that, with the solution in figures 7-9, the frame of the insulating glazing must have free spaces at the edges 7A-7D for deformation of the LSC 5.

It should be noted that the portion 50 of the spacer 17 comprises an intermediate yielding or resilient or plastics component 55 which facilitates the deformation of the portion 50, whilst maintaining the rigidity of the insulating glazing.

Usually, the photovoltaic cells 10 are coupled according to a specific plan, as shown in figure 10B. After this coupling, the distribution of photons emitted along the perimeter of an LSC is not constant, as shown by figure 10A.

More particularly, by way of non-limiting example, figure 10A shows the emission profile of a side of an LSC with a length of 15 cm (where the number of photons emitted is indicated in standardised units relative to the maximum value emitted from the centre of the side of the concentrator). It should be noted that the non-homogenous distribution of emission of light is an intrinsic characteristic of the LSC, and is therefore independent from the dimensions thereof. In particular, the number of photons emitted from the centre of a side is always greater than the number of the photons emitted from the two ends of the side itself. Consequently, the photovoltaic cells coupled thereto are exposed to an intensity of light radiation which is spatially not uniform.

This leads to the fact that the current produced by a string of solar cells with equal dimensions connected to one another in series, and coupled to the side of the concentrator, is limited to the current produced by the least lit cell of the string.

This effect is shown in the histogram in figure 10A, where the spatial distribution of the electrical current produced by solar cells 10 with an identical area (histogram) follows the non-homogenous distribution of photons emitted from the side of the concentrator (continuous line). Consequently, the cells 10 which are placed at the ends of the side produce current which is significantly less than the cells which are placed at the centre of the side itself. This introduces an intrinsic limit to the electrical current which can be extracted from the entire string of cells, which limit is specifically dictated by the current generated by the least lit cells.

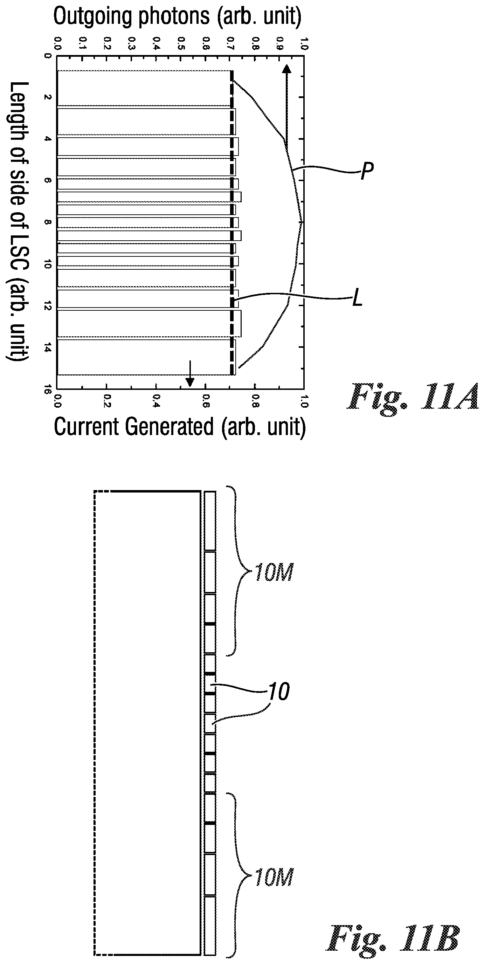

A solution to this problem which makes it possible to maximise the electrical power which can be obtained from a solar concentrator is to use photovoltaic cells with different dimensions, such as to compensate for the different intensity of light emission along the side of the concentrator. This can be carried out according to the plan in figure 11B, in which cells 10M with a larger area are placed at sections with lower lighting of the side of the concentrator. In this case, since the current is proportional to the product of density of lighting and area lit, as indicated in figure 11A, the profile of electrical current generated does not follow the irregular development of the photons emitted along the side of the concentrator, but on the other hand is constant. This results in a total value of electrical current which can be extracted from the side of the concentrator which is significantly greater than the case previously described for solar cells with constant dimensions.

According to a further characteristic of the invention, the insulating glazing 1 operates as a self-powered "smart window". In this case, as shown in figure 12, the electrical energy produced by the light which strikes the luminescent solar concentrator or LSC 5 is directed to a battery 81 which is secured on the frame of the insulating glazing or on the counter-frame 80 of a window, by means of an electrical connection 811.

The battery 81 is connected to the photovoltaic cells 10 of the insulating glazing 1. Various users or devices which can have various functions can be connected to the battery 81. For example, the battery 81 can be connected by means of an electrical cable 83 to an electro-chromic device 82 which can obscure the insulating glazing, and/or a device (electric motor) for movement of a curtain (not shown), and/or a Wi-Fi repeater, LED lights, or another type of lighting device, and/or alarm devices (which for example are connected to the opening of the window, or are volumetric), and/or a Hi-Fi repeater or other electrical devices, for example sensors of various types; all of these are placed on the interior or the exterior of the insulating glazing.

An electrical socket and/or a USB socket 84 can also be connected via a cable 87 to the battery 81.

It is also possible to use the cells 10 in order to supply power directly to said electronic devices, without needing to provide a battery.

A description has been provided of one embodiment of the present invention. It will be appreciated that other variants are possible, such as the one which includes the panels 4 and 6 and a plurality of intermediate LSCs 5. These solutions also come within the scope of the invention as defined by the appended claims.

## Claims

1. Insulating glazing (1) comprising two panels (4, 6) which are made of transparent material, such as glass or plastics material, disposed at outer faces of the insulating glazing (1) and at least one intermediate panel (5) which is placed between said two panels (4, 6), the intermediate panel (5) cooperating at opposite edges (7A, 7C) with at least one spacer unit (17) which spaces it from each adjacent panel made of transparent material (4, 6), the spacer unit (17) comprising two portions (19, 20) with a form in the shape of an overturned "U" delimiting a channel (21) in which an end (22) of the intermediate panel (5) is placed, said portions with a form in the shape of an overturned "U" (19, 20) being interconnected by a wall (27) delimiting said channel (21), said spacer unit (17) comprising means (30) which can receive the deformation of the intermediate panel, **characterised in that** said intermediate panel is a luminescent solar concentrator (5), the luminescent solar concentrator (5) being deformable in a direction (H) which is orthogonal to an axis (Z) perpendicular to its faces with a larger area, further to a variation of the temperature thereof and thermal expansion thereof, said spacer unit (17) comprising electrical contact means (40) which can cooperate by sliding with connectors of the luminescent solar concentrator, said electrical contact means being adapted to be connected by sliding to an electrical circuit on the exterior of the insulating glazing.

2. Insulating glazing according to claim 1, **characterised in that** said luminescent solar concentrator (5) comprises an electrical circuit constituted by solar cells (10) with a variable dimension, which electrical circuit can maximise the electrical current which can be extracted.

3. Insulating glazing according to claim 1, **characterised in that** said means which can receive the deformation of the luminescent solar concentrator comprise, placed within the channel (21) of the spacer unit (17), a compensator element (30), which is placed between said wall (27) of the channel (21) and said end (22) of the luminescent solar concentrator (5), said element being yielding, and being able to withstand and compensate for the deformation of the luminescent solar concentrator (5) with which this element is in contact.

4. Insulating glazing according to claim 3, **characterised in that** the two portions (19, 20) of the spacer unit (17) are detached from the luminescent solar concentrator (5).

5. Insulating glazing according to claim 3, **characterised in that** said compensator element is alternatively made of plastics material, rubber, or of foam material.

6. Insulating glazing according to claim 1, **characterised in that** it is connected to electrical and/or electronic devices, preferably by means of at least one battery (81) which can accumulate the energy produced by the luminescent solar concentrator (5), and to which said electrical and/or electronic devices are connected directly, these devices being at least one out of actuator means (84) for a curtain, electro-chromatic means (82), alarm devices, or electrical power supply sockets (88).

7. Insulating glazing according to claim 6, **characterised in that** said electrical/electronic devices (82, 84, 88) are associated with a counter-frame (80) of the insulating glazing (1).

8. Window or French window comprising an insulating glazing according to claim 1.

## Patentansprüche

1. Isolierverglasung (1), umfassend zwei Platten (4, 6), die aus transparentem Material, wie beispielsweise Glas oder Kunststoff, bestehen, die an Außenflächen der Isolierverglasung (1) angeordnet sind, und mindestens eine Zwischenplatte (5), die zwischen den zwei Platten (4, 6) platziert ist, wobei die Zwischenplatte (5) an gegenüberliegenden Rändern (7A, 7C) mit mindestens einer Abstandhaltereinheit (17) zusammenwirkt, die sie von jeder benachbarten Platte beabstandet, die aus transparentem Material (4, 6) besteht, wobei die Abstandhaltereinheit (17) zwei Abschnitte (19, 20) mit einer Form in der Gestalt eines umgekehrten "U" umfasst, die einen Kanal (21) begrenzen, in dem ein Ende (22) der Zwischenplatte (5) platziert ist, wobei die Abschnitte mit einer Form in der Gestalt eines umgekehrten "U" (19, 20) durch eine Wand (27) miteinander verbunden sind, die den Kanal (21) begrenzt, wobei die Abstandhaltereinheit (17) Mittel (30) umfasst, welche die Verformung der Zwischenplatte aufnehmen können, **dadurch gekennzeichnet, dass** die Zwischenplatte ein lumineszierender Solarkonzentrator (5) ist, wobei der lumineszierende Solarkonzentrator (5) in eine Richtung (H) verformbar ist, die rechtwinklig zu einer Achse (Z) liegt, welche senkrecht zu seinen Flächen mit einer größeren Grundfläche liegt, bezugnehmend auf eine Veränderung seiner Temperatur und seine thermische Ausdehnung, wobei die Abstandhaltereinheit (17) elektrische Kontaktmittel (40) umfasst, die durch Gleiten mit Verbindern des lumineszierenden Solarkonzentrators zusammenwirken können, wobei die elektrischen Kontaktmittel dafür eingerichtet sind, durch Gleiten mit einer elektrischen Schaltung außerhalb der Isolierverglasung verbunden zu werden.

2. Isolierverglasung nach Anspruch 1, **dadurch gekennzeichnet, dass** der lumineszierende Solarkonzentrator (5) eine elektrische Schaltung umfasst, die aus Solarzellen (10) mit variablen Abmessungen gebildet ist, wobei die elektrische Schaltung den elektrischen Strom maximieren kann, der extrahiert werden kann.

3. Isolierverglasung nach Anspruch 1, **dadurch gekennzeichnet, dass** die Mittel, welche die Verformung des lumineszierenden Solarkonzentrators aufnehmen können, platziert in dem Kanal (21) der Abstandhaltereinheit (17), ein Kompensatorelement (30) umfassen, das zwischen der Wand (27) des Kanals (21) und dem Ende (22) des lumineszierenden Solarkonzentrators (5) platziert ist, wobei das Element nachgiebig und in der Lage ist, der Verformung des lumineszierenden Solarkonzentrators (5), mit dem dieses Element in Kontakt steht, standzuhalten und die Verformung auszugleichen.

4. Isolierverglasung nach Anspruch 3, **dadurch gekennzeichnet, dass** die zwei Abschnitte (19, 20) der Abstandhaltereinheit (17) von dem lumineszierenden Solarkonzentrator (5) getrennt sind.

5. Isolierverglasung nach Anspruch 3, **dadurch gekennzeichnet, dass** das Kompensatorelement alternativ aus Kunststoff, Kautschuk oder aus Schaumstoff gebildet ist.

6. Isolierverglasung nach Anspruch 1, **dadurch gekennzeichnet, dass** sie mit elektrischen und/oder elektronischen Geräten verbunden ist, vorzugsweise mittels mindestens einer Batterie (81), welche die Energie speichern kann, die durch den lumineszierenden Solarkonzentrator (5) erzeugt wird, und mit der die elektrischen und/oder elektronischen Geräte direkt verbunden sind, wobei diese Geräte mindestens eines von Aktormitteln (84) für eine Verdunklung, elektrochromatische Mittel (82), Alarmierungsgeräten oder Energieversorgungs-Steckdosen (88) sind.

7. Isolierverglasung nach Anspruch 6, **dadurch gekennzeichnet, dass** die elektrischen/elektronischen Geräte (82, 84, 88) mit einem Gegenrahmen (80) der Isolierverglasung (1) assoziiert sind.

8. Fenster oder Terrassentür, eine Isolierverglasung nach Anspruch 1 umfassend.

## Revendications

1. Vitrage isolant (1) comprenant deux panneaux (4, 6) faits en matériau transparent, tel que du verre ou de la matière plastique, disposés sur les faces extérieures du vitrage isolant (1) et au moins un panneau intermédiaire (5) placé entre lesdits deux panneaux (4, 6), le panneau intermédiaire (5) coopérant sur les bords opposés (7A, 7C) avec au moins une unité d'espacement (17) qui l'espace de chaque panneau adjacent en matériau transparent (4, 6), l'unité d'espacement (17) comprenant deux parties (19, 20) ayant une forme en « U » renversé délimitant un canal (21) dans lequel est placée une extrémité (22) du panneau intermédiaire (5), lesdites parties ayant une forme en « U » renversé (19, 20) étant interconnectées par une paroi (27) délimitant ledit canal (21), ladite unité d'espacement (17) comprenant des moyens (30) pouvant recevoir la déformation du panneau intermédiaire, **caractérisé en ce que** ledit panneau intermédiaire est un concentrateur solaire luminescent (5), le concentrateur solaire luminescent (5) étant déformable dans une direction (H) orthogonale à un axe (Z) perpendiculaire à ses faces ayant une plus grande surface, suite à une variation de sa température et à sa dilatation thermique, ladite unité d'espacement (17) comprenant des moyens de contact électrique (40) pouvant coopérer par glissement avec des connecteurs du concentrateur solaire luminescent, lesdits moyens de contact électrique étant aptes à être connectés par glissement à un circuit électrique à l'extérieur du vitrage isolant.

2. Vitrage isolant selon la revendication 1, **caractérisé en ce que** ledit concentrateur solaire luminescent (5) comprend un circuit électrique constitué de cellules solaires (10) de dimension variable, lequel circuit électrique permet de maximiser le courant électrique pouvant être extrait.

3. Vitrage isolant selon la revendication 1, **caractérisé en ce que** lesdits moyens pouvant recevoir la déformation du concentrateur solaire luminescent comprennent, disposés à l'intérieur du canal (21) de l'unité d'espacement (17), un élément compensateur (30), placé entre ladite paroi (27) du canal (21) et ladite extrémité (22) du concentrateur solaire luminescent (5), ledit élément cédant, et pouvant supporter et compenser la déformation du concentrateur solaire luminescent (5) avec lequel cet élément est en contact.

4. Vitrage isolant selon la revendication 3, **caractérisé en ce que** les deux parties (19, 20) de l'unité d'espacement (17) sont détachées du concentrateur solaire luminescent (5).

5. Vitrage isolant selon la revendication 3, **caractérisé en ce que** ledit élément compensateur est fabriqué soit en matière plastique, en caoutchouc ou en mousse.

6. Vitrage isolant selon la revendication 1, **caractérisé en ce qu'**il est connecté à des appareils électriques et/ou électroniques, de préférence au moyen d'au moins une batterie (81) pouvant accumuler l'énergie produite par le concentrateur solaire luminescent (5), et à laquelle sont directement connectés lesdits appareils électriques et/ou électroniques, ces dispositifs étant au moins l'un parmi des moyens d'actionnement (84) d'un rideau, des moyens électro-chromatiques (82), des dispositifs d'alarme, ou des prises d'alimentation électrique (88).

7. Vitrage isolant selon la revendication 6, **caractérisé en ce que** lesdits appareils électriques/électroniques (82, 84, 88) sont associés à un contre-châssis (80) du vitrage isolant (1).

8. Fenêtre ou porte-fenêtre comportant un vitrage isolant selon la revendication 1.
